Europäisches Patentamt

European Patent Office

Office européen des brevets

(19)

(11) **EP 0 753 937 B1**

(12) **EUROPEAN PATENT SPECIFICATION**

(45) Date of publication and mention
of the grant of the patent:
**09.10.2002 Bulletin 2002/41**

(51) Int Cl.[7]: **H03H 7/24**, H03K 17/16

(21) Application number: **95830304.2**

(22) Date of filing: **14.07.1995**

(54) **Method and circuit for the suppression of switching distortion in digitally controlled attenuators**

Verfahren und Schaltung zur Unterdrückung von Schaltgeräuschen in digital gesteuerten Abschwächern

Procédé et circuit pour la suppression de bruit de commutation dans des atténuateurs contrôlés numériquement

(84) Designated Contracting States:
**DE FR GB IT**

(43) Date of publication of application:
**15.01.1997 Bulletin 1997/03**

(73) Proprietor: **STMicroelectronics S.r.l.**
**20041 Agrate Brianza (Milano) (IT)**

(72) Inventors:
• **Onetti, Andrea Mario**
**I-27100 Pavia (IT)**
• **Procurato, Sylvia**
**I-48100 Ravenna (IT)**

(74) Representative: **Pellegri, Alberto et al**
**c/o Società Italiana Brevetti S.p.A.**
**Piazza Repubblica, 5**
**21100 Varese (IT)**

(56) References cited:
**US-A- 4 683 386**

• **PATENT ABSTRACTS OF JAPAN vol. 9, no. 244 (E-346) (1967) 30 September 1985 & JP-A-60 093 812 (NIPPON DENKI K. K.) 25 May 1985**
• **PATENT ABSTRACTS OF JAPAN vol. 8, no. 139 (E-253) 28 June 1984 & JP-A-59 049 009 (SANYO DENKI K K)**

**Description**

The present invention concerns analog circuits for signal processing that are adjustable or automatically controllable by means of digital control circuits. More in particular this invention concerns digitally controlled attenuators.

In analog signals processors it is often necessary to adjust the signal level, for instance the volume of an audio signal. A remarkable system automation or improved ergonomic criteria of certain manual commands privilege the adoption of digital control techniques of the operation parameters of certain analog circuits of the signal processing system.

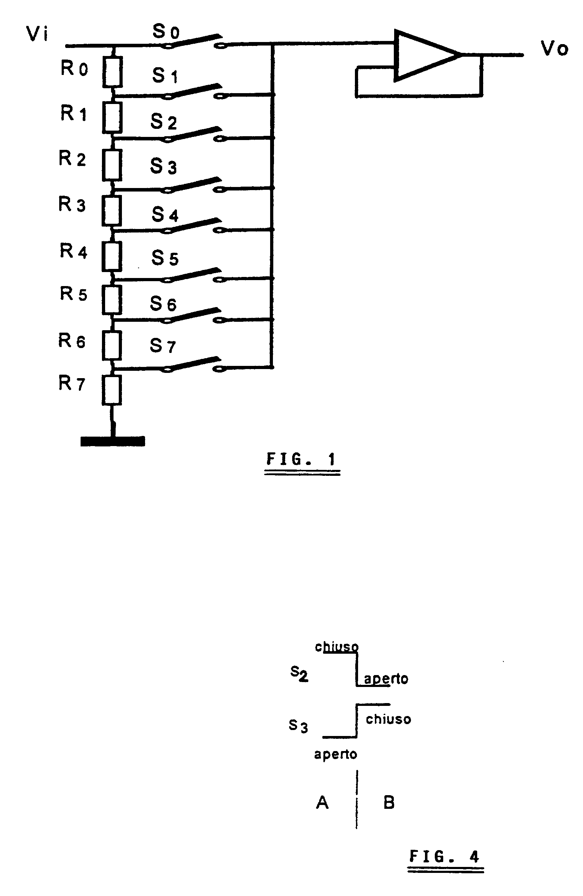

Typical of these systems, is the employment of digitally controlled attenuators. These are in essence constituted by a voltage divider functionally connected between a first signal input node and a common ground node of the circuit. The voltage divider has a plurality of taps selectable by as many selection switches digitally driven in a mutually exclusive way via software. According to the scheme of Fig. 1, each selectable switch is capable of connecting a certain tap of the voltage divider to a second circuital node (downstream of said first signal input node) of the signal path (for example to the input of an output or coupling buffer). The selection of a particular tap is effected via software command in the form of a «word» composed for example a string of «zeros» and a single «one» that identifies the selected switch. When selecting a different attenuation value, the switches subject to the change of configuration rapidly switch in a mutually exclusive way. The signal is therefore subjected to a higher or lower attenuation in an abrupt manner. When the amplitude variation is relatively large, as in the case of audio systems, this abrupt change may manifest itself by way of a sharp noise (clic). This «switching distortion» is further enhanced when it takes place while the signal is at peak amplitude.

The document US-A-4 683 386 of T. KAMIWARA discloses a digital controlled volume attenuator of the type discussed above.

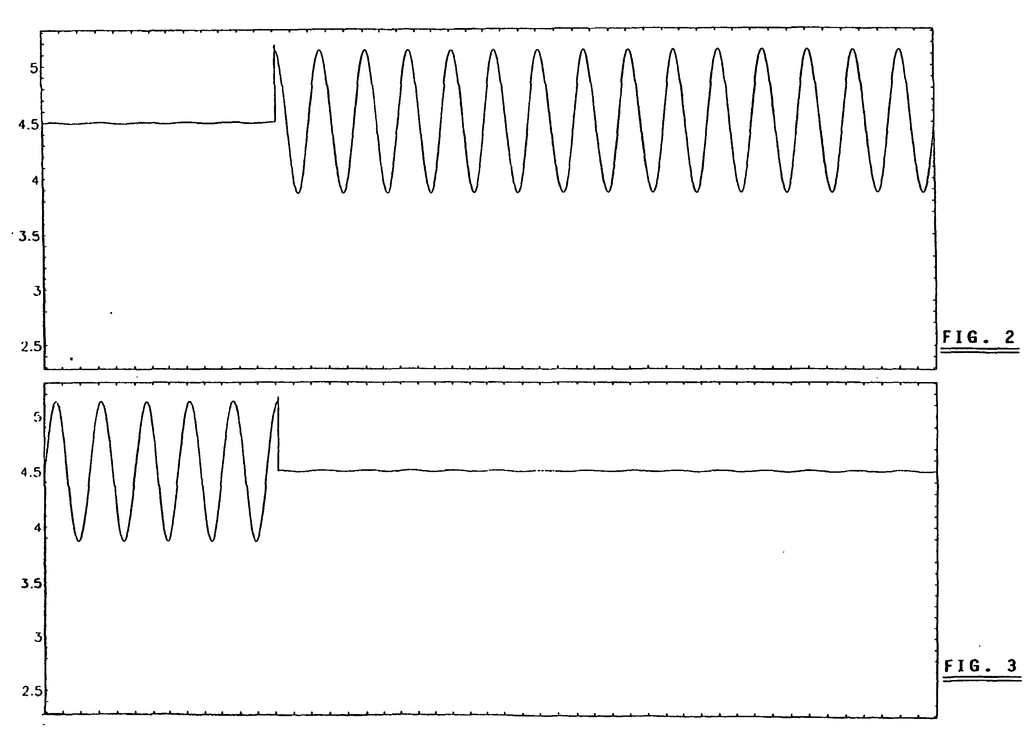

Figures 2 and 3 show the switching transient for a 1KHz sinusoid, respectively for a decrement and an increment of the attenuation.

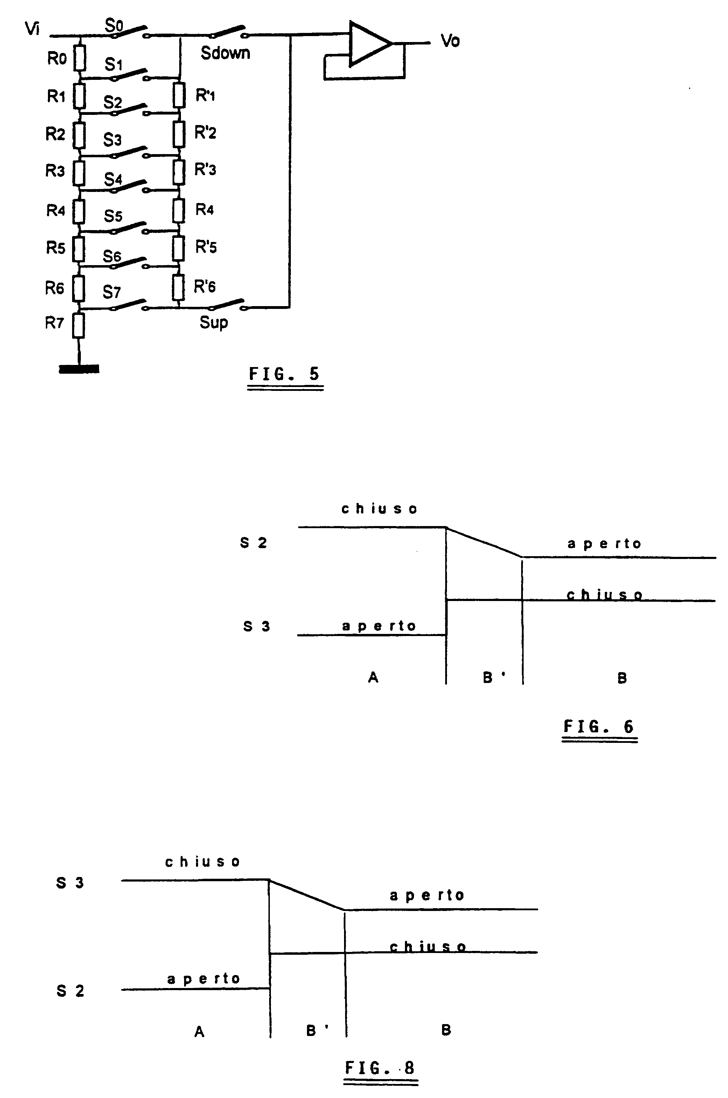

By referring to the circuit diagram of Fig. 1 and supposing that the system be in the condition (A), having the $S_2$ switch closed along the signal path according to the functional scheme illustrated in Fig. 4, the attenuation in such a condition (A) will be given generally by the following expression:

$$A = \frac{R_2 + R_3 + ... + R_n}{R_1 + R_2 + R_3 + ... + R_n}$$

When, through the digital control of the switches, the system is commanded in a different condition (B) where the $S_3$ switch is the one «selected», then the attenuation becomes:

$$B = \frac{R_3 + ... + R_n}{R_1 + R_2 + R_3 + ... + R_n}$$

Obviously, a similar amplitude jump occurs when switching over from the condition (B) into the condition (A), as schematically shown in Fig. 4.

In many cases, specially when the configuration of the digitally controlled attenuator is modified through rather large steps, say of 6 to 10dB, the dynamic distortion that occurs at the switching instant might generate unpleasant audible effects. On the other hand, a more gradual modification of the attenuation might be effected by commanding the execution of a series of attenuation incrementing and decrementing switchings, each switching producing a sufficiently small change of attenuation in order to gradually reach the required (commanded) attenuation level. This system involves a nonnegligible software complication, often incompatible with other requisites of availability of the microprocessor that conducts the execution of adjustment commands for a plurality of functions of the signal processing system.

In view of these difficulties, a system has now been found for effectively suppressing the dynamic distortion due to a change of configuration of a digitally controlled attenuator that does not require any complication of the software, but rather, is capable of suppressing said distortions substantially via hardware, in an extremely simple way.

Fundamentally, the method of the invention consists in discriminating between a situation of a commanded increment or decrement of the attenuation and to consequently drive in phase opposition a pair of switches that select the signal path downstream of the selection switch that selects the new required level of attenuation or in other words the particular tap of the resistive voltage divider, producing a rapid closing of the switch that is selected via software for modifying the attenuation and a slowed down opening of the deselected switch according to a preestablished switch driving ramp. During the opening phase of the switch deselected by the command of modification of the attenuation, the portion or section of the resistive voltage divider pertaining to the commanded change of «tap» turns out to be connected in parallel with a shunt resistance whose value is adequate to sensibly reduce the rate of change of the attenuation according to the voltage ramp that drives the opening of the deselected switch.

The result of all this is a gradual decrease or increase of the attenuation towards the new value selected by the digital command, obtained via hardware in an extremely simple way.

The attenuation network of this invention is characterized by the use of a pair of switches driven in phase opposition by a circuit capable of discriminating between a command or increment of decrement of the attenuation. The pair of switches have a current terminal coupled in common to a node of the signal path downstream of the attenuation network, while the other current terminals of the switches are respectively connected to one and to the other end of a second resistive voltage divider having a plurality of taps, respectively connected to the switches for the mutually exclusive selection of the taps of the voltage divider of the attenuator.

The various aspects of the invention and its advantages will be even more evident through the following description of several embodiments and by referring to the figures herein enclosed, where:

Figure 1 is a basic circuit diagram of a digitally controlled attenuator, according to the prior art;

Figures 2 and 3 show the switching transients in one and the other direction of change for a 1KHz sinusoid;

Figure 4 is an explanatory diagram of the switching mode of the attenuator depicted in Fig. 1 from a condition (A) to a condition (B) and viceversa;

Figure 5 is a basic circuit diagram of a digitally controlled attenuator made in conformity with the present invention;

Figures 6 and 7 respectively show the functioning mode and a switching transient in the case of an increment of the attenuation;

Figure 8 and 9 respectively show the functioning mode and a switching transient in the case of a decrement of the attenuation.

By referring to Fig. 5, the attenuation network of the invention is characterized by the use of a pair of switches driven in phase opposition (Sup and Sdown), which select the signal path downstream of the tap selection switch ($S_0$, $S_1$, ..., $S_7$), in function of a logic control signal that discriminates between either an increment or decrement of the attenuation to be implemented by modifying the configuration of the selection switches $S_0$, ... $S_7$. This information or control signal of the pair of switches Sup and Sdown, may be easily generated by the digital control system, which receives (either by a command of the operator or by an impulse produced by an automatic control system) a certain instruction for modifying the current configuration of the selection switches $S_0$, ... $S_7$.

For instance, the driving circuit of the pair of switches Sup and Sdown of the attenuation network of the invention may sense the derivative of the attenuation. Of course, such a circuit is in itself trivial and a thorough illustration thereof is not considered necessary for an exhaustive description of the invention.

According to the invention, the selection switches $S_0$ ... $S_7$ are not connected directly in common to the virtual ground node represented by the input of the output buffer, but instead connected to as many taps or nodes of a series of resistors ($R_1'$, $R_2'$, $R_6'$) that form a chain, or second resistive «voltage divider», connected between the discrimination switches, Sup and Sdown, as shown in the figure.

Case A - Increment of the attenuation

Assume that from a certain level of attenuation, as produced by a configuration where the $S_2$ switch is closed and the others are open, the attenuation must be changed to a higher level by closing the switch $S_3$ and opening the switch $S_2$. The command produced by the digital control system will be such as to determine the Sdown switch to be closed and the Sup switch to be opened. In the above described case, the attenuation for a starting condition (A) will be generally given by the following expression:

$$A = \frac{R_2 + R_3 + ... + R_n}{R_1 + R_2 + R_3 + ... + R_n}$$

Following to the command of attenuation increment, a suitable logic circuit command a fast closing of the $S_3$ switch, while the opening of the $S_2$ switch is effected by using a relatively slow ramp signal to drive the switch to an OFF state. This can usually be implemented by connecting a capacitor of suitable value to a purposely dedicated external pin of the semiconductor device, so that the driving signal of the switch $S_2$ turns out to be shaped like a ramp, in function of the rise of the voltage on the capacitor (with a certain time constant). Any expert technician is conversant with this well known technique that is widely used, for example when implementing a so-called «soft muting» function in audio processors. Although requiring a dedicated pin, the use of an external capacitor permits to adapt the time constant to the requirements of a particular application. The attenuation network of the invention is such that following to the fast switching on of the switch $S_3$ and until reaching a complete interdiction of the deselected switch $S_2$, the instantaneous value of the attenuation will be given by an expression of the type below:

$$B' = \frac{R_2//R'_2 + ... + R_n}{R_1 + R_2//R'_2 + R_3 + ... + R_n}$$

By appropriately dimensioning of the resistors $R'_n$ of the second or auxiliary voltage divider, it is trivial to impose the following conditions:

$$B' < A$$

$$A - B' \leq \varepsilon$$

where $\varepsilon$ represents the largest change or jump of attenuation short of producing noticeable effects (for example unable to produce an audible clic in audio processors).

The slow turn-off (opening) of the switch $S_3$ determines a gradual approach toward the imposed new level of attenuation (new condition B), that will be given by the following expression:

$$B = \frac{R_3 + ... + R_n}{R_1 + R_2 + R_3 + ... + R_n}$$

The diagrams of Fig. 6 show in a schematic way the functioning of the system during a phase of increment of the attenuation.

Fig. 7 illustrates a simulated switching transient for the case of a sinusoidal signal having a frequency of 1KHz to be subjected to an amplitude variation (attenuation) of 40dB, through a switch ($S_2$) turn-off ramp of 10 milliseconds (ms).

*Case B - Decrement of the attenuation*

In this case, the control circuitry or in other words the circuit that senses the derivative of the attenuation, turns on immediately the switch Sup and simultaneously turns off the switch Sdown.

Assuming as a starting condition the one that was attained during the preceding phase of increase of the attenuation, described above and substantially according to which the attenuation (B) is given substantially by the following expression:

$$B = \frac{R_3 + ... + R_n}{R_1 + R_2 + R_3 + ... + R_n}$$

then, at the time of the fast turn-on of the switch $S_2$ and until the switch $S_3$ reaches a complete off-state, the attenuation will be instantaneously given by the following expression:

$$B' = \frac{R_3 + ... + R_n}{R_1 + R_2 /\!/ R'_2 + R_3 + ... + R_n}$$

whereby the following conditions will be fulfilled:

$$B' > B$$

$$B' - B \leq \varepsilon$$

The slow turn-off of the switch $S_3$ determines

a gradual reaching of the final value (A) of the attenuation that is given by the following expression:

$$A = \frac{R_2 + R_3 + ... + R_n}{R_1 + R_2 + R_3 + ... + R_n}$$

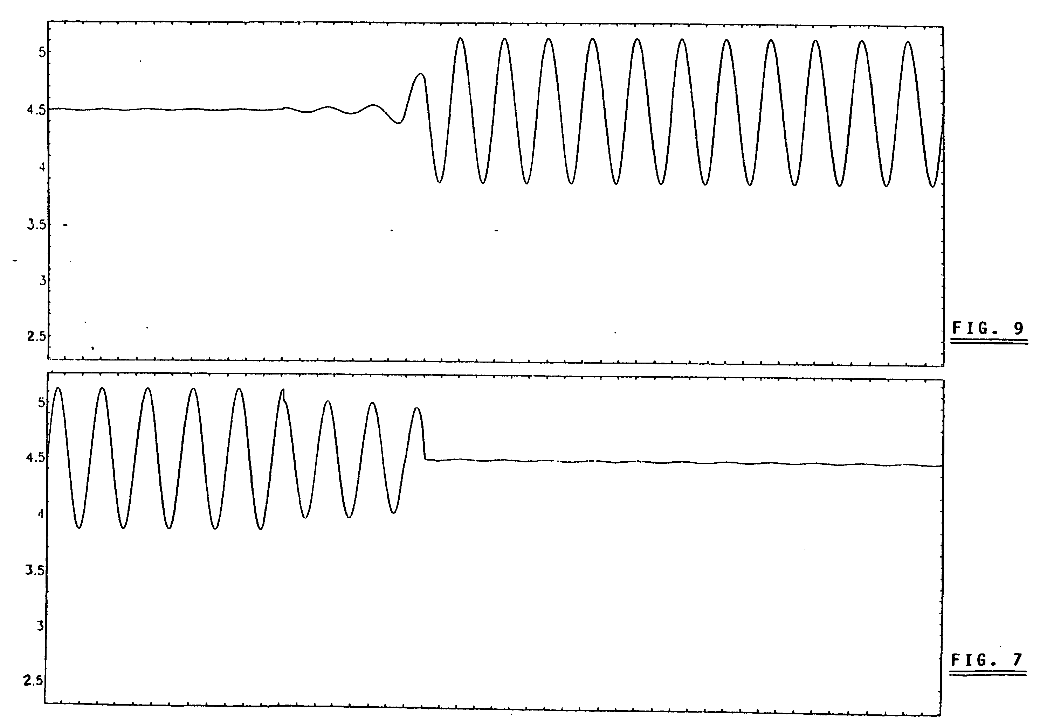

Even in this case, the operation is diagrammatically shown in Fig. 8, whereas Fig. 9 shows the switching transient obtained by simulation for the case of a sinusoidal signal having a frequency of 1KHz, undergoing a change of attenuation of 40dB and using a decrement ramp whose duration is 10ms.

It is evident that the objective of suppressing the dynamic distortion when commanding large attenuation changes is fully met without resorting to a complication of the software and/or to a burdening of the supervising microprocessor but rather by hardware means with a negligible increment of the circuital complexity.

Moreover, it will be clear to any skilled person that the manner in which the signal for discriminating the direction of the commanded modification of the attenuation level is derived, may be different and in any case easily implementable by the use of extremely simple logic circuits. In addition, the way of generating a turn-off signal for the deselected switch in the form of a ramp of predefinable duration, may be different, all being well known and easily realizable by a technician with ordinary knowledge of electronic circuits.

**Claims**

1. A method for suppressing switching distortion in digitally controlled attenuators constituted by a resistive voltage divider (R0, R1, ..., R7) having a plurality of output taps that are selectable in a mutually exclusive way via software by a plurality of switches (S0, S1, ..., S7), **characterized in that** it comprises

   discriminating between a command of increment or decrement of the attenuation and consequently driving in phase opposition a pair of further switches (Sup, Sdown);

   determining the fast turn-on of a selected one of said plurality of switches and a slowed down turn-off according to a preestablished driving ramp of a deselected one of said plurality of switches (S0, S1, ..., S7) in execution of a command of a change of attenuation;

   reducing the rate of change of attenuation during said slowed down turn-off of the deselected switch by connecting in parallel to the portion of said resistive voltage divider (R0, R1, ..., R7) comprised between said selected and deselected switches a shunt resistance (R'1, R'2, ...,

R'6) which is selected in the signal path downstream of said selected switch by said pair of further switches (Sup, Sdown).

2. An attenuation network comprising a first resistive voltage divider (R0, R1, ..., R7) coupled to a first node of a signal path and a common ground node and having a plurality of output taps selectable in a mutually exclusive way by a plurality of switches (S0, S1, ..., S7) which is configured by a digital datum generated via software, each of said switches coupling a respective tap of said divider (R0, R1, ..., R7) to a second node of the signal path, **characterized in that** comprises

a pair of further switches (Sup, Sdown) each having a first current terminal coupled in common to said second node and a second current terminal coupled to one and to the other end, respectively, of a second resistive voltage divider (R'1, R'2, ..., R'6) having a plurality of taps, each coupled to a respective switch of said plurality of switches (S0, S1, ..., S7) for mutually exclusively selecting the taps of said first resistive voltage divider (R0, R1, ..., R7);

means for driving in phase opposition said pair of further switches (Sup, Sdown) in function of a discrimination between an increment or a decrement of the attenuation command;

means for turning off the switch of said plurality of switches (S0, S1, ..., S7) deselected by the new digital datum through a relatively slow ramp compared with a relatively fast turning on of the switch selected by the new digital datum.

3. The attenuation network according to claim 2, **characterized in that** said means for driving in phase opposition said pair of further switches (Sup, Sdown) comprise a circuit capable of sensing the sign of the derivative of the attenuation.

4. The attenuation network according to claim 2, **characterized in that** said means for driving in phase opposition said pair of further switches (Sup, Sdown) comprise a circuit capable of generating a logic signal representative of the direction of change of the attenuation of the contingent command.

5. An analog audio processor **characterized by** comprising

a digitally controlled attenuator constituted by an attenuator network as defined in claim 2.

**Patentansprüche**

1. Verfahren zur Unterdrückung der Schaltverzerrung in digital gesteuerten Abschwächern, die aus einem widerstandsfähigen, eine Mehrheit Ausgangsbuchsen aufweisenden Spannungsteiler (R0, R1, ..., R7) bestehen, wobei die Ausgangsbuchsen in gegenseitig ausschließender Weise softwaremäßig durch eine Mehrheit Schalter (S0, S1, ..., S7) auswählbar sind,

**dadurch gekennzeichnet, dass** es

Unterscheidung zwischen einem Abschwächungsinkrement- bzw. - dekrementsbefehl und folglich Ansteuerung in Gegenphase eines Paares Schalter (Sup, Sdown);

Bewirken der schnellen Einschaltung eines selektierten Schalters aus der genannten Mehrheit Schalter und einer verlangsamten Ausschaltung nach einer vorausgewählten Ansteuerungsrampe eines deselektierten Schalters aus der genannten Mehrheit Schalter (S0 S1, ..., S7) bei der Ausführung eines Abschwächungsänderungsbefehls;

Verminderung der Geschwindigkeit der Abschwächungsänderung während der genannten verlangsamten Ausschaltung des deselektierten Schalters durch Parallelschaltung zu demjenigen Teil des genannten widerstandsfähigen Spannungsteilers (R0, R1, ..., R7), der zwischen die genannte selektierte und deselektierte Schalter angeordnet ist eines Nebenwiderstandes (R'1, R'2, ..., R'6), der im Signalpfad abwärts vom genannten selektierten Schalter durch das genannte Paar weitere Schalter (Sup, Sdown) ausgewählt wird umfasst.

2. Abschwächungsnetzwerk, umfassend einen ersten widerstandsfähigen Spannungsteiler (R0, R1, ..., R7), der mit einem ersten Knotenpunkt eines Signalpfades und einem gemeinsamen Erdensknoten gekoppelt ist, wobei das Abschwächungsnetzwerk eine Mehrheit Ausgangsbuchsen aufweist, die in gegenseitig ausschließender Weise durch eine Mehrheit Schalter (S0 S1, ..., S7), die durch ein softwaremäßig erzeugtes Datum gestaltet werden auswählbar sind, wobei jeder der genannten Schalter eine entsprechende Buchse des genannten Teilers (R0, R1, ..., R7) mit einem zweiten Knotenpunkt des Signalpfades koppelt,

**dadurch gekennzeichnet, dass** es

ein Paar weitere Schalter (Sup, Sdown), jeder von denen ein erstes Stromverschluss, der gemeinsam mit dem genannten zweiten Knotenpunkt gekoppelt ist, bzw. ein zweites Stromverschluss, der mit beiden Enden gekoppelt ist, eines zweiten widerstandsfähigen Spannungsteilers (R0, R1, ..., R7), der mit einer Mehrheit Ausgangsbuchsen ausgestattet ist aufweist, die mit je einem Schalter der genannten Mehrheit Schalter (S0, S1, ..., S7) gekoppelt sind, damit die Buchsen des genannten ersten widerstandsfähigen Spannungsteilers (R0, R1, ..., R7) in gegenseitig ausschließender Weise ausgewählt werden;

Mittel zur gegenphasigen Ansteuerung des genannten Paares weitere Schalter (Sup, Sdown) infolge einer Unterscheidung zwischen einem Inkrement bzw. Dekrement des Abschwächungsbefehls;

Mittel zum Ausschalten desjenigen Schalters der genannten Mehrheit Schalter (S0, S1, ..., S7), das durch das neue digitale Datum deselektiert worden ist, einer Rampe entlang, die gegenüber der verhältnismäßig schnellen Einschaltung des durch das neue digitale Datum selektierten Schalters verhältnismäßig langsam ist,

umfasst.

3. Abschwächungsnetzwerk nach Anspruch 2, **dadurch gekennzeichnet, dass** die genannte Mittel zur Ansteuerung in Gegenphase des genannten Paares weitere Schalter (Sup, Sdown) eine Schaltung umfassen, die in der Lage ist, das Vorzeichen der derivierten Funktion der Abschwächung nachzuweisen.

4. Abschwächungsnetzwerk nach Anspruch 2, **dadurch gekennzeichnet, dass** die genannte Mittel zur Ansteuerung in Gegenphase des genannten Paares weitere Schalter (Sup, Sdown) eine Schaltung umfassen, die in der Lage ist ein logisches Signal zu erzeugen, das repräsentativ der Änderungsrichtung der Abschwächung des kontingenten Befehls ist.

5. Analoger Audioprozessor, **dadurch gekennzeichnet, dass** es einen digitalgesteuerten aus einem Abschwächungsnetzwerk nach Anspruch 2 bestehenden Abschwächer

umfasst.


## Revendications

1. Méthode pour supprimer la distorsion dynamique dans des atténuateurs contrôlés numériquement constitués par un diviseur résistif de tension (R0, R1, ..., R7) avec plusieurs prises de sortie sélectionnables de manière mutuellement exclusive a l'aide de logiciel au moyen d'une pluralité d'interrupteurs (S0, S1, ..., S7), **caractérisée en ce qu'**elle comprend

la discrimination d'une commande d'incrément ou décrément de l'atténuation et le pilotage conséquent en opposition de phase d'une paire d'interrupteurs ultérieurs (Sup, Sdown);

la détermination de la fermeture rapide d'un sélectionné de la susdite pluralité d'interrupteurs et l'ouverture ralentie selon une rampe prédéterminée de pilotage d'un désélectionné de la susdite pluralité d'interrupteurs (S0, S1, ..., S7) en exécution d'une commande de changement d'atténuation ;

la réduction de la variation d'atténuation au cours de la susdite ouverture ralentie de l'interrupteur désélectionné par connexion en parallèle a la portion dudit diviseur résistif de tension (R0, R1, ..., R7) comprise entre les susdits interrupteurs sélectionnés et désélectionnés d'une résistance de shuntage (R'1, R'2, ..., R'6) qui est sélectionnée dans le parcours de signal en aval dudit interrupteur sélectionné par ladite paire d'interrupteurs ultérieurs (Sup, Sdown).

2. Réseau d'atténuation comprenant un premier diviseur résistif de tension (R0, R1, ..., R7) couplé avec un premier noeud d'un parcours de signal et un noeud commun de masse et ayant une pluralité de prises de sortie sélectionnables de manière mutuellement exclusive au moyen d'une pluralité d'interrupteurs (S0, S1, ..., S7) qui est configurée par une donnée numérique générée a l'aide d'un logiciel, chacun desdits interrupteurs couplant une prise respective dudit diviseur (R0, R1, ..., R7) avec un deuxième noeud du parcours de signal, **caractérisé en ce qu'**il comprend une paire d'interrupteurs ultérieurs (Sup, Sdown) ayant chacun d'eux une première borne de courant couplée en commun avec ledit deuxième noeud et une deuxième borne de courant couplée respectivement avec l'un et l'autre bout d'un deuxième diviseur résistif de courant (R'1, R'2, ..., R'6) ayant une pluralité de bornes, chacune couplée avec un interrupteur respectif de ladite pluralité d'interrupteurs (S0, S1, ..., S7) pour ne sélectionner mutuellement que les bornes dudit premier diviseur résistif de courant (R1, R2, ..., R7);

des moyens pour commander en opposition de phase ledit couple d'interrupteurs ultérieurs (Sup, Sdown) en fonction d'une discrimination entre un incrément ou décrément du commande d'atténuation;

des moyens pour ouvrir l'interrupteur de ladite pluralité d'interrupteurs (S1, S2, ..., S7) désélectionné par la nouvelle donnée numérique au moyen d'une rampe relativement lente par rapport à la fermeture relativement rapide de l'interrupteur sélectionné par la nouvelle donnée numérique.

3. Réseau d'atténuation selon la revendication 2, **caractérisé en ce que** lesdits moyens pour commander en opposition de phase ledit couple d'interrupteurs ultérieurs (Sup, Sdown) comprennent un circuit capable de relever le signe de la dérivée de l'atténuation.

4. Réseau d'atténuation selon la revendication 2, **caractérisé en ce que** lesdits moyens pour commander en opposition de phase ledit couple d'interrupteurs ultérieurs (Sup, Sdown) comprennent un circuit capable de générer un signal logique représentatif de la direction de changement de l'atténuation de la commande contingente.

**5.** Processeur audio analogique **caractérisé en ce qu'**il comprend un atténuateur contrôlé numériquement constitué d'un réseau atténuateur tel que défini dans la revendication 2.

FIG. 1

chiuso

$S_2$      aperto

$S_3$      chiuso

aperto

A      B

FIG. 4

8

FIG. 2

FIG. 3

EP 0 753 937 B1

EP 0 753 937 B1

FIG. 5

FIG. 6

FIG. 8

10

EP 0 753 937 B1

FIG. 9

FIG. 7

11